# EUROPÄISCHE PATENTANMELDUNG

(11) **EP 3 288 349 A1**
(43) Veröffentlichungstag der Anmeldung: **28.02.2018**
(21) Anmeldenummer: 16185652.1
(22) Anmeldetag: 25.08.2016
(51) Int. Cl.: H05K 1/14, H05K 1/18, H05K 3/36, H01L 25/07, H01L 25/00

(54) **LEISTUNGSMODUL, MODULANORDNUNG UND VERFAHREN ZUR HERSTELLUNG EINES LEISTUNGSMODULS**

(71) Anmelder: Siemens Aktiengesellschaft, 80333 München (DE)
(72) Erfinder: Bigl, Thomas, 91074 Herzogenaurach (DE); Hensler, Alexander, 90766 Fürth (DE); Neugebauer, Stephan, 91058 Erlangen (DE); Pfefferlein, Stefan, 90562 Heroldsberg (DE); Weisgerber, Volker, 90768 Fürth (DE); Wetzel, Ulrich, 91058 Erlangen (DE)

(57) **Zusammenfassung**

Die Erfindung betrifft ein Leistungsmodul (1) umfassend eine erste Leiterplatte (2) aufweisend eine erste Oberfläche (3) und eine der ersten Oberfläche (3) gegenüberliegend angeordnete zweite Oberfläche (4) sowie zumindest ein HalbleiterBauelement (5), welches an der ersten Oberfläche (3) angeordnet ist. Weiterhin betrifft die Erfindung eine Modulanordnung (30) aufweisend zumindest zwei derartige Leistungsmodule (1). Schließlich betrifft die Erfindung ein Verfahren zur Herstellung eines Leistungsmoduls (1).

Um verbesserte Leistungsmodule (1) bzw. Modulanordnungen (30) bereitzustellen, wird unter anderem vorgeschlagen, dass das Leistungsmodul (1) eine zweite Leiterplatte (6) aufweisend eine dritte Oberfläche (7) und eine der dritten Oberfläche (7) gegenüberliegend angeordnete vierte Oberfläche (8) sowie eine erste Flexleiterplatte (9) aufweist, wobei die erste Leiterplatte (2) und die zweite Leiterplatte (6) derart aufeinander gestapelt angeordnet sind, dass die erste Oberfläche (3) der dritten Oberfläche (7) zugewandt ist, und wobei die erste Leiterplatte (2) mit der zweiten Leiterplatte (6) mittels der ersten Flexleiterplatte (9) elektrisch kontaktiert ist.

## Beschreibung

Die Erfindung betrifft ein Leistungsmodul umfassend eine erste Leiterplatte aufweisend eine erste Oberfläche und eine der ersten Oberfläche gegenüberliegend angeordnete zweite Oberfläche sowie zumindest ein Halbleiter-Bauelement, welches an der ersten Oberfläche angeordnet ist.

Weiterhin betrifft die Erfindung eine Modulanordnung aufweisend zumindest zwei derartige Leistungsmodule.

Schließlich betrifft die Erfindung ein Verfahren zur Herstellung eines Leistungsmoduls.

Derartige Vorrichtungen bzw. ein derartiges Verfahren kommen in einer Vielzahl von Anwendungen in der Leistungselektronik zum Einsatz.

Die Mehrzahl der heutigen Leistungsmodule, zum Beispiel High Power IGBT Module, bestehen aus einer Vielzahl von komplexen Bauelementen, die in aufwändigen Verfahren zusammengesetzt sind. Angefangen von speziell angepassten Modulgehäusen bis hin zu gebondeten und vergossenen Leistungshalbleitern. Ein kompakter Aufbau wird durch die Aufbautechnik und die thermische Anbindung an die Kühlfläche bzw. Kühlkörper schwierig. Weiterhin schränken unerwünschte Induktivitäten durch die elektrischen Verbindungselemente, zum Beispiel Bonddrähte, die Schaltqualität nicht unerheblich ein. Auch ist die einseitige Anbindung des Halbleiters an die kühlende Seite des Moduls nicht sehr effizient. Besonders die vielen Zwischenlagen bis hin zum Kühlkörper erhöhen den thermischen Widerstand merklich.

Um einen kompakten Aufbau zu erzielen, wird bisher oftmals versucht, die Halbleiter beidseitig direkt mit oder ohne vermittelnde Kupferflächen an den Kühlkörper zu binden, was als Sandwichbauweise bekannt ist. Allerdings verlangt diese Variante sehr ebene Flächen auf dem Kühlkörper und dem Halbleiter. Durch die thermische Ausdehnung der Komponenten muss ein mechanischer Toleranzausgleich erfolgen. Wenn aber dabei Auflageflächen nicht exakt gefertigt wurden, können die Halbleiterchips brechen. Auch lässt sich eine feste Verbindung mit dem Kühlkörper und dem Halbleiter nur mit speziellen Verfahren, wie zum Beispiel Kleben oder Löten erzielen, deren Zuverlässigkeit und Aufwand problematisch sind.

Aus der EP 2 040 524 A1 sind ein Verfahren zum Herstellen eines Leistungsmoduls sowie ein Leistungsmodul bekannt, wobei zunächst ein Gehäuse mit Anschlusskontakten bestückt wird, anschließend eine Schaltplatine mit dem mit den Anschlusskontakten bestückten Gehäuse zusammengefügt wird und schließlich die Anschlusskontakte mit der Schaltplatine jeweils an mindestens einer Kontaktstelle stoffschlüssig verbunden werden.

Aus der DE 10 2014 203 309 A1 sind ein Verfahren zum Herstellen eines Elektronikmoduls sowie ein Elektronikmodul umfassend eine Leiterplatte sowie mindestens ein elektronisches Leistungsbauelement bekannt.

Eine Aufgabe der Erfindung ist es, verbesserte Leistungsmodule bzw. Modulanordnungen bereitzustellen.

Eine Lösung der Aufgabe ergibt sich bei einem Leistungsmodul der eingangs genannten Art dadurch, dass das Leistungsmodul weiterhin aufweist:
- eine zweite Leiterplatte aufweisend eine dritte Oberfläche und eine der dritten Oberfläche gegenüberliegend angeordnete vierte Oberfläche,
wobei die erste Leiterplatte und die zweite Leiterplatte derart aufeinander gestapelt angeordnet sind, dass die erste Oberfläche der dritten Oberfläche zugewandt ist, und
- eine erste Flexleiterplatte,
wobei die erste Leiterplatte mit der zweiten Leiterplatte mittels der ersten Flexleiterplatte elektrisch kontaktiert ist.

Eine weitere Lösung der Aufgabe ergibt sich durch eine Modulanordnung der eingangs genannten Art dadurch, dass die Modulanordnung zumindest zwei der vorgeschlagenen Leistungsmodule sowie eine weitere Leiterplatte aufweist, wobei die zumindest zwei Leistungsmodule auf einander gegenüberliegenden Oberflächen der weiteren Leiterplatte angeordnet sind.

Eine weitere Lösung der Aufgabe ergibt sich durch ein Verfahren zur Herstellung des vorgeschlagenen Leistungsmoduls umfassend die Verfahrensschritte:
- Bereitstellen eines Leiterplatten-Stranges umfassend die erste Leiterplatte, die erste Flexleiterplatte und die zweite Leiterplatte, sowie ggf. eine zweite Flexleiterplatte und eine dritte Leiterplatte,
- Gestapeltes Anordnen der ersten Leiterplatte und der zweiten Leiterplatte derart, dass die erste Oberfläche der dritten Oberfläche zugewandt ist,
- Ggf. gestapeltes Anordnen der ersten Leiterplatte, der zweiten Leiterplatte und der dritten Leiterplatte derart, dass die zweite Oberfläche oder die vierte Oberfläche der sechsten Oberfläche zugewandt ist.

Vorzugsweise sind die erste Leiterplatte und die zweite Leiterplatte im Wesentlichen flach bzw. quaderförmig oder plattenförmig ausgestaltet, wobei die genannten erste bis vierte Oberflächen die größten Oberflächen des Quaders bzw. der Platte sind. Die jeweilige Leiterplatte kann bspw. als PCB ("printed circuit board") oder als keramisches DCB-Substrat ("direct bonded copper") oder dergleichen ausgestaltet sein. Denkbar ist weiterhin, dass die Leiterplatten zusammen mit der jeweiligen Flexleiterplatte einstückig als eine einzige Flexleiterplatte ausgebildet sind. Das jeweilige Halbleiter-Bauelement kann auf die erste Oberfläche der ersten Leiterplatte bspw. geklebt, gesintert oder gelötet werden. Vorzugsweise weist die jeweilige Leiterplatte Leiterbahnen auf, unter anderem auch, um das jeweilige Halbleiter-Bauelement elektrisch zu verbinden.

Die elektrische Verbindung bzw. Kontaktierung der ersten Leiterplatte mit der zweiten Leiterplatte gelingt mittels der ersten Flexleiterplatte, welche oftmals auch flexible Leiterplatte genannt wird, für welche bspw. Polyimid und darauf angebrachte, strukturierte Leiterbahnen, insbesondere Kupferbahnen, verwendet werden können. Die Flexleiterplatte kann auch mehrlagig aufgebaut sein, so dass sich an eine erste Polyimidschicht eine Leiterbahnschicht, anschließend eine zweite Polyimidschicht und ggf. weitere Leiterbahnenschichten und Polyimidschichten anschließen.

Wird im Folgenden allgemein von Leiterplatten gesprochen, so sollen darunter zuerst die erste Leiterplatte, die zweite Leiterplatte, ggf. die dritte Leiterplatte und ggf. die weitere Leiterplatte verstanden werden. Die im Folgenden allgemeinen Erläuterungen zu Leiterplatten beziehen sich daher nicht auf die soeben erläuterte erste Flexleiterplatte und ggf. die zweite Flexleiterplatte, es sei denn, dies ist direkt angegeben.

Bei dem vorgeschlagenen Leistungsmodul werden die erste Leiterplatte und die zweite Leiterplatte gestapelt und derart angeordnet, dass die erste Oberfläche der dritten Oberfläche zugewandt ist. Die gestapelte Anordnung weist dabei vorzugsweise senkrecht zur Stapelrichtung eine größere räumliche Ausdehnung als parallel zur Stapelrichtung auf.

Vorzugsweise ist der Leiterplatten-Strang für das vorgeschlagene Verfahren derart aufgebaut, dass die erste Flexleiterplatte zwischen der ersten Leiterplatte und der zweiten Leiterplatte angeordnet ist.

Insbesondere dank der Flexleiterplatte, mittels welcher die beiden erläuterten Leiterplatten miteinander elektrisch kontaktiert sind, kann eine mechanische Flexibilität der gesamten Anordnung und eine niedrige Induktivität der Verbindungsleitung erreicht werden. Die niedrige Induktivität wird insbesondere dadurch erreicht, dass verglichen bspw. mit herkömmlichen Bonddrähten vergleichsweise kurze und breite Leiterbahnen zur Verbindung der erläuterten beiden Leiterplatten realisiert werden können. Dank der Flexleiterplatte ist es möglich, die Flexleiterplatte bspw. als Innenlage in den starren Teilen der erläuterten Leiterplatten zu verpressen oder die Flexleiterplatte am Rand der starren Leiterplatten zu kontaktieren. Dadurch sind die erläuterten Leiterplatten und gegebenenfalls weitere Leiterplatten über die Flexleiterplatte in einem so genannten Nutzen bereits miteinander verbunden. Das ermöglicht eine gleichzeitige Bestückung aller Leiterplatten, wodurch Kosten eingespart werden können. Außerdem muss die Flexleiterplatte nicht später separat an die Leiterplatten ankontaktiert werden. Weiterhin können Kontaktflächen der jeweiligen Leiterplatte an den jeweiligen Einsatz angepasst werden, so dass ein so genannter Breakout von der Chipgeometrie durchgeführt werden kann.

Insbesondere ist es möglich, ein Leistungsmodul in "Sandwich-Bauweise" herzustellen, wobei ein derart hergestelltes Leistungsmodul vorteilhafterweise zwischen Kühlkörperelementen eingespannt wird, ohne dass für jedes Bauelement ein eigener Toleranzausgleich innerhalb der Spannvorrichtung erfolgen muss. Die Sandwich-Bauweise eignet sich somit besonders für ein beidseitiges, kompaktes Kühlkonzept, wodurch besonders leistungsstarke und kompakte Leistungsmodule geschaffen werden können.

Da kritische Toleranzen, bspw. bezüglich der Planheit von Flächen, an den Bauteilen nicht ausgeschlossen werden können oder man nur mit einem kostenaufwändigen Auswahlverfahren passende Teile aussortieren kann, sind mechanisch flexible Bauelemente, wie hier in Form eines Leistungsmoduls mit einer Flexleiterplatte, ein möglicher Lösungsansatz. Die vorgestellte Idee beschreibt ein kompaktes Teilmodul, in dem die Halbleiterbauelemente so auf einer Leiterplatte angebracht sind, dass durch ein flexibles Zwischenteil und kurze Flexleiter-Kontakte sowohl die mechanische Flexibilität und eine niedrige Induktivität als auch eine optimale und direkte Kühlkörperanbindung hergestellt werden können. Somit kann man sehr einfach Module in "Sandwichbauweise" zwischen Kühlkörperelementen einspannen, ohne dass für jedes Bauelement ein eigener Toleranzausgleich innerhalb der Spannvorrichtung erfolgen muss.

Insgesamt wird somit ein Leistungsmodul mit vorteilhaften mechanischen und vorteilhaften elektrischen Eigenschaften geschaffen, wodurch ein verbessertes Leistungsmodul und eine entsprechend verbesserte Modulanordnung bereitgestellt werden.

Insbesondere können mehrere Halbleiter-Bauelemente bzw. Leistungsmodule oder Modulanordnungen zusammengeschaltet werden, um komplette Halbbrücken oder Vollbrücken eines Stromrichters durch das erläuterte, flexible Leistungsmodul zu realisieren bzw. integrieren. Weiterhin können mehrere Leistungsmodule im Rahmen der vorgeschlagenen Modulanordnung vorgesehen sein, um auch komplexere Schaltungen eines Stromrichters zu realisieren, wodurch die Modulanordnung weiter verbessert wird. Dabei können auch mehrere der vorgeschlagenen Leistungsmodule auf einer jeweiligen Oberfläche der weiteren Leiterplatte angeordnet werden.
Vorzugsweise wird das vorgeschlagene Leistungsmodul bzw. die vorgeschlagene Modulanordnung in einem Stromrichter verwendet, welcher insbesondere für einen Betrieb mit einer elektrischen Leistung im Kilowatt-Bereich, bspw. 10 kW und mehr, ausgelegt ist. Insbesondere ist ein Einsatz des vorgeschlagenen Leistungsmoduls, der vorgeschlagenen Modulanordnung oder eines entsprechenden Stromrichters in einem elektrisch oder hybrid-angetriebenen Fahrzeug, insbesondere einem Elektroauto, vorgesehen.

Bei einer vorteilhaften Ausgestaltung der Erfindung ragt die erste Flexleiterplatte aus der gestapelten Anordnung der ersten Leiterplatte und der zweiten Leiterplatte seitlich in einer ersten Richtung heraus.

Die erste Flexleiterplatte stellt somit eine elektrische Verbindung zwischen den beiden gestapelten Leiterplatten her, wozu die erste Flexleiterplatte aus der gestapelten Anordnung der ersten und zweiten Leiterplatte, also im Wesentlichen senkrecht zur Stapelrichtung, herausragt. Bspw. ist also denkbar, dass die erste Flexleiterplatte im Wesentlichen einen U-förmig Querschnitt aufweist und einer der beiden Stege des U mit der ersten Leiterplatte und der andere der beiden Stege des U mit der zweiten Leiterplatte verbunden ist. Die Anbindung der ersten Flexleiterplatte an die jeweilige Leiterplatte kann dabei derart ausgestaltet sein, dass die jeweilige Flexleiterplatte als Innenlage in den zu verbindenden, starren Leiterplatten verpresst und galvanisch ankontaktiert ist. Weiterhin kann die erste Flexleiterplatte am Rand der jeweiligen Oberfläche der jeweiligen Leiterplatte aufliegen. Denkbar ist auch, dass die erste Flexleiterplatte an einer seitlichen Oberfläche der jeweiligen Leiterplatte anliegt.

Bei einer weiteren vorteilhaften Ausgestaltung der Erfindung umfasst das Leistungsmodul eine dritte Leiterplatte aufweisend eine fünfte Oberfläche und eine der fünften Oberfläche gegenüberliegend angeordnete sechste Oberfläche, wobei die erste Leiterplatte, die zweite Leiterplatte und die dritte Leiterplatte derart aufeinander gestapelt angeordnet sind, dass die zweite Oberfläche oder die vierte Oberfläche der sechsten Oberfläche zugewandt ist, und eine zweite Flexleiterplatte, wobei die erste Leiterplatte oder die zweite Leiterplatte mit der dritten Leiterplatte mittels der zweiten Flexleiterplatte elektrisch kontaktiert ist.

Somit umfasst das vorgeschlagene Leistungsmodul drei Leiterplatten, die untereinander mittels zweier Flexleiterplatten verbunden sind. Für die Anordnung der drei Leiterplatten sind dabei zwei Alternativen denkbar. Zum einen ist eine Anordnung möglich, bei welcher die erste Leiterplatte in Stapelrichtung zwischen der zweiten Leiterplatte und der dritten Leiterplatte angeordnet ist, so dass die zweite Oberfläche der sechsten Oberfläche zugewandt ist. Zum anderen ist eine Anordnung möglich, bei welcher die zweite Leiterplatte in Stapelrichtung zwischen der ersten Leiterplatte und der dritten Leiterplatte angeordnet ist, so dass die vierte Oberfläche der sechsten Oberfläche zugewandt ist.

Vorzugsweise ist der Leiterplatten-Strang für das vorgeschlagene Verfahren derart aufgebaut, dass die erste Flexleiterplatte zwischen der ersten Leiterplatte und der zweiten Leiterplatte angeordnet ist und die zweite Flexleiterplatte zwischen der zweiten Leiterplatte und der dritten Leiterplatte angeordnet ist. Ausgehend von einem derartigen Leiterplatten-Strang kann somit je nach Erfordernis die oben erläuterte erste Alternative oder zweite Alternative durch unterschiedliches Falten der beiden Flexleiterplatten realisiert werden. Denkbar ist weiterhin, dass die erste Flexleiterplatte zwischen der ersten Leiterplatte und der zweiten Leiterplatte angeordnet ist und die zweite Flexleiterplatte zwischen der ersten Leiterplatte und der dritten Leiterplatte angeordnet ist.

Bei einer weiteren vorteilhaften Ausgestaltung der Erfindung ragt die zweite Flexleiterplatte aus der gestapelten Anordnung der ersten Leiterplatte, der zweiten Leiterplatte und der dritten Leiterplatte seitlich in einer der ersten Richtung entgegengesetzten zweiten Richtung heraus.

Ähnlich wie die erste Flexleiterplatte stellt die zweite Flexleiterplatte eine elektrische Verbindung zwischen der zweiten Leiterplatte oder der ersten Leiterplatte einerseits und der dritten Leiterplatte andererseits her, wozu die zweite Flexleiterplatte aus der gestapelten Anordnung der Leiterplatten, also im Wesentlichen senkrecht zur Stapelrichtung, herausragt. Dabei ist eine ähnliche Ausgestaltung wie für die erste Flexleiterplatte denkbar, also insbesondere ein U-förmiger Querschnitt und eine ähnliche Anbindung auch der zweiten Flexleiterplatte in Bezug auf die zweite Leiterplatte bzw. erste Leiterplatte und die dritte Leiterplatte.

Bei einer weiteren vorteilhaften Ausgestaltung der Erfindung umfasst das zumindest eine Halbleiter-Bauelement einen Transistor, insbesondere in Form eines "bare die", wobei das Leistungsmodul zumindest zwei elektrische Kontaktstellen, insbesondere für den Gate-Anschluss sowie für den Source- oder den Drain-Anschluss des Transistors, sowie zumindest eine weitere elektrische Kontaktstelle, insbesondere für den Drain- oder den Source-Anschluss des Transistors, aufweist.

Bei dieser Ausgestaltung des vorgeschlagenen Leistungsmoduls sind ein jeweiliger Transistor und insgesamt zumindest drei jeweilige elektrische Kontaktstellen vorgesehen. Vorzugsweise sind zumindest zwei der elektrischen Kontaktstellen an jener Oberfläche einer der Leiterplatten angeordnet, welche der gestapelten Anordnung der Leiterplatten abgewandt ist, und die zumindest eine weitere elektrische Kontaktstelle ist an jener Oberfläche einer der Leiterplatten angeordnet, welche ebenfalls der gestapelten Anordnung der Leiterplatten abgewandt ist und dabei der zuvor genannten Oberfläche gegenüberliegt.

Für das Beispiel eines Leistungsmoduls mit der ersten Leiterplatte und der darauf gestapelten zweiten Leiterplatte befinden sich die zumindest zwei elektrischen Kontaktstellen somit auf der zweiten Oberfläche oder der vierten Oberfläche und die zumindest eine weitere elektrische Kontaktstelle entsprechend auf der vierten Oberfläche oder der zweiten Oberfläche.

Für das Beispiel eines Leistungsmoduls mit drei gestapelten Leiterplatten befinden sich die zumindest zwei elektrischen Kontaktstellen gemäß der oben erläuterten ersten Alternative somit auf der vierten Oberfläche oder der fünften Oberfläche und die zumindest eine weitere elektrische Kontaktstelle entsprechend auf der fünften Oberfläche oder der vierten Oberfläche. Gemäß der oben erläuterten zweiten Alternative befinden sich die zumindest zwei elektrischen Kontaktstellen auf der zweiten Oberfläche oder der fünften Oberfläche und entsprechend die zumindest eine weitere elektrische Kontaktstelle auf der fünften Oberfläche oder der zweiten Oberfläche.

Handelt es sich bei dem jeweiligen Transistor um einen Feldeffekttransistor, so können die insgesamt zumindest drei elektrischen Anschlussstellen für die drei Anschlüsse Gate, Drain und Source des jeweiligen Transistors verwendet werden. Für den Fall, dass der jeweilige Transistor als Bipolartransistor ausgestaltet ist, können die genannten zumindest drei elektrischen Anschlussstellen für die drei Anschlüsse Basis, Emitter und Kollektor des jeweiligen Transistors verwendet werden.

Vorzugsweise liegt der jeweilige Transistor in Form eines "bare die", d.h. ohne ein eigenes Gehäuse, vor, so dass ein derartiger Transistor direkt auf der ersten Leiterplatte aufgebracht und elektrisch mit dieser verbunden ist. Dadurch wird ein besonders kompaktes Leistungsmodul ermöglicht.

Ein derartiges Leistungsmodul kann bspw. in einem Gleichrichter oder einem Wechselrichter eingesetzt werden.

Bei einer weiteren vorteilhaften Ausgestaltung der Erfindung umfasst das zumindest eine Halbleiter-Bauelement eine Diode.

Zum elektrischen Anschluss der Diode können zwei zusätzliche Kontaktstellen vorgesehen sein, die entweder auf einer der der äußeren Oberflächen des Leistungsmoduls oder auf den beiden sich gegenüberliegenden äußeren Oberflächen des Leistungsmoduls angeordnet sind, wobei diese äußeren Oberflächen des Leistungsmoduls weiter oben im Zusammenhang mit der Ausgestaltung mit einem Transistor schon erläutert wurden.

Ein derartiges Leistungsmodul kann bspw. bei einem Gleichrichter eingesetzt werden.

Vorzugsweise weist das vorgeschlagene Leistungsmodul sowohl zumindest einen Transistor, wie oben erläutert, als auch zumindest eine Diode auf, wobei die jeweilige Diode bspw. als Freilaufdiode für den jeweiligen Transistor eingesetzt wird. Diese Ausgestaltung des Leistungsmoduls wird vorzugsweise bei einem Gleichrichter, Wechselrichter oder generell Stromrichter eingesetzt, wobei ein derartiges Leistungsmodul bspw. zwischen einem Zwischenkreiskondensator und einer elektrischen Phase einer Wechselspannung angeordnet ist. Die genannte Wechselspannung kann bspw. eingangsseitig die Netzspannung oder bspw. ausgangsseitig die Wechselspannung für eine zu versorgende Last, insbesondere einen Elektromotor, darstellen.

Bei einer weiteren vorteilhaften Ausgestaltung der Erfindung weist die erste Leiterplatte sowie vorzugsweise auch die zweite Leiterplatte jeweils einen Kupferkern auf.

Durch den jeweiligen Kupferkern gelingt eine besonders gute Entwärmung der jeweiligen Leiterplatte und des insgesamt vorgeschlagenen Leistungsmoduls. Dies wird dadurch erreicht, dass die abzuführende Wärme innerhalb der jeweiligen Leiterplatte gut verteilt wird. Weiterhin gelingt auch eine gute Abgabe der Abwärme entlang der Stapelrichtung an benachbarte Elemente des Leistungsmoduls, insbesondere Kühlkörper, da eine größere Fläche senkrecht zur Stapelrichtung für den Wärmetransport verwendet werden kann.

Bei einer weiteren vorteilhaften Ausgestaltung der Erfindung weist das Leistungsmodul ein Gehäuse auf, welches die gestapelte Anordnung der ersten Leiterplatte, der zweiten Leiterplatte und ggf. der dritten Leiterplatte zumindest teilweise einhaust.

Das Gehäuse kann bspw. wannenförmig mit einem im Wesentlichen U-förmigen Querschnitt ausgestaltet sein, wobei eine der Leiterplatten am Boden der Wanne und eine andere der Leiterplatten an der Öffnung der Wanne angeordnet sein können. Dies erlaubt eine gute Abfuhr der Abwärme und einen leichten Zugang für elektrische Anschlüsse für die jeweilige Leiterplatte an der Öffnung der Wanne. Im Anschluss an die Öffnung der Wanne kann dabei insbesondere die weitere Leiterplatte der vorgeschlagenen Modulanordnung angeordnet sein.

Insbesondere für elektrische Anschlüsse kann auch am Boden der Wanne zumindest eine Durchgangsöffnung vorgesehen sein, durch die jeweils auch gut Abwärme an die Umgebung abgegeben werden kann. So kann sich bspw. an den Boden der Wanne ein Kühlkörper anschließen.

Bei einer weiteren vorteilhaften Ausgestaltung der Erfindung ist die gestapelte Anordnung der ersten Leiterplatte, der zweiten Leiterplatte und ggf. der dritten Leiterplatte zumindest teilweise mit einer Vergussmasse, insbesondere mittels eines Silikonvergusses, umschlossen.

Durch den Verguss wird die bis dahin vergleichsweise bewegliche und flexible, gestapelte Anordnung der Leiterplatten fixiert und mechanisch stabil. Diese mechanische Stabilität macht sich bspw. dadurch bemerkbar, dass das Leistungsmodul dank des Vergusses gegenüber Vibrationen oder sonstigen Schwingungen wesentlich unempfindlicher ist. Vorzugsweise umgibt die Vergussmasse die erste Flexleiterplatte und ggf. die zweite Flexleiterplatte, so dass diese besonders flexiblen Bauteile fest positioniert werden. Neben einer Verbesserung der mechanischen Eigenschaften des vorgeschlagenen Leistungsmoduls kann durch den Verguss gleichzeitig eine gute elektrische Isolierung erreicht werden.

Vorzugsweise weist das Leistungsmodul das oben erläuterte Gehäuse auf, so dass der Verguss die im Gehäuse verbleibenden Hohlräume größtenteils oder vollständig ausfüllt.

Bei einer weiteren vorteilhaften Ausgestaltung der Erfindung weist das Leistungsmodul dabei zumindest ein Federelement auf, mittels welchem jeweils die gestapelte Anordnung der ersten Leiterplatte, der zweiten Leiterplatte und ggf. der dritten Leiterplatte in Richtung der Stapelrichtung zwischen einem ersten Körper und einem zweiten Körper eingespannt werden kann.

Das jeweilige Federelement ist mechanisch elastisch in Richtung der Stapelrichtung der Leiterplatten verformbar. Mittels des jeweiligen Federelements kann die gestapelte Anordnung der Leiterplatten somit in der Stapelrichtung zusammengedrückt werden, wodurch ein zuverlässiges Anliegen der Leiterplatten aufeinander und ggf. von weiteren Elementen, die zwischen den Leiterplatten angeordnet sind, gewährleistet werden kann. Dies ist von Vorteil, da die jeweiligen Bauteile somit stets in einem guten thermischen Kontakt sind und eine gute Abfuhr von Abwärme somit stets gewährleistet ist. Dank des jeweiligen Federelements ist das Leistungsmodul auch weniger anfällig in Bezug auf Vibrationen oder sonstige Schwingungen, indem das jeweilige Federelement eine ausreichend große Kraft auf die Anordnung der Leiterplatten ausübt.

Der erste und/oder der zweite Körper kann bzw. können bspw. das oben erläuterte Gehäuse, die weitere Leiterplatte der vorgeschlagenen Modulanordnung oder ein oder mehrere Kühlkörper sein.

Bei einer weiteren vorteilhaften Ausgestaltung der Erfindung weist das Leistungsmodul zumindest ein flexibles Ausgleichselement auf, welches jeweils auf einer der Oberflächen der ersten Leiterplatte, der zweiten Leiterplatte und ggf. der dritten Leiterplatte angeordnet ist.

Das jeweilige, flexible Ausgleichselement ist in Stapelrichtung elastisch und kann bspw. als eine Art Matte oder Kissen quaderförmig ausgestaltet sein. Vorzugsweise ist das jeweilige, flexible Ausgleichselement aus Silikon und bildet somit ein Silikon-Pad. Insbesondere überdeckt das jeweilige, flexible Ausgleichselement die jeweilige Leiterplatte in Stapelrichtung betrachtet zumindest teilweise. Insbesondere bei der ersten Leiterplatte kann das jeweilige, flexible Ausgleichselement auch das jeweilige Halbleiter-Bauelement zumindest teilweise überdecken.

Um Herstellungskosten zu reduzieren, wird das jeweilige, flexible Ausgleichselement noch während der Bereitstellung des Stranges der Leiterplatten und somit schon auf einer der Oberflächen der Leiterplatten angebracht, noch bevor die erläuterte Stapelung der Leiterplatten vorgenommen wird.

Das jeweilige, flexible Ausgleichselement kann dabei zwischen zwei benachbarten Leiterplatten angeordnet sein oder an einer äußeren Oberfläche der gestapelten Anordnung der Leiterplatten.

Bei einer weiteren vorteilhaften Ausgestaltung der Erfindung weist das Leistungsmodul zumindest einen Zentrierstift zur Positionierung der ersten Leiterplatte, der zweiten Leiterplatte und ggf. der dritten Leiterplatte auf, wobei die jeweilige Leiterplatte vorzugsweise eine jeweilige Aussparung zur Aufnahme des jeweiligen Zentrierstifts aufweist.

Die jeweilige Aussparung kann als Durchgangsöffnung oder als konkave Stelle, insbesondere konkaver Konus, an der jeweiligen Leiterplatte ausgestaltet sein, so dass der jeweilige Zentrierstift entweder durch die Aussparung hindurchgeführt oder zumindest eingeführt werden kann. Indem die Position der jeweiligen Aussparung genau vorgegeben ist, kann im Zusammenspiel mit dem Zentrierstift somit eine genaue Positionierung der jeweiligen Leiterplatte erreicht werden. Dies erlaubt, dass die Leiterplatten im Sinne von Poka-Yoke nur in der vorher definierten Anordnung gefügt werden können, wodurch eine fehlerhafte Kontaktierung vermieden wird und somit ein Vorteil beim Herstellen durch eine Prozessabsicherung erreicht wird. Ferner können die elektrischen Leiterbahnen entsprechend passgenau ausgelegt werden, wodurch die Induktivität des Leistungsmoduls reduziert werden kann. Weiterhin können Wärmeleit-Pfade über die Leiterplatten hinweg genauer eingehalten werden, indem bspw. Kupferkerne der Leiterplatten passgenau zueinander definiert werden, wodurch die Kühlung des Leistungsmoduls verbessert wird.

Insbesondere kann der jeweilige Zentrierstift auch als Schraube ausgestaltet sein, mittels welcher die gestapelte Anordnung der Leiterplatten verschraubt wird. Gleichzeitig kann bei dieser Ausgestaltung ein Verspannen der gestapelten Anordnung der Leiterplatten in Stapelrichtung vorgenommen werden.

Bei einer weiteren vorteilhaften Ausgestaltung der Erfindung weist das Leistungsmodul einen dritten Körper und einen vierten Körper auf, wobei die gestapelte Anordnung der ersten Leiterplatte, der zweiten Leiterplatte und ggf. der dritten Leiterplatte in Richtung der Stapelrichtung zwischen dem dritten Körper und dem vierten Körper angeordnet sind, wobei der dritte Körper ein Kühlkörper ist und wobei der vierte Körper ein Kühlkörper oder eine weitere Leiterplatte ist.

Durch eine derartige Ausgestaltung kann eine besonders gute Kühlung des Leistungsmoduls erreicht werden. Der jeweilige Kühlkörper kann bspw. plattenförmig aus einem Metall oder einer Metalllegierung, bspw. Aluminium bzw. eine Aluminiumlegierung, ausgestaltet sein, wobei die Platte vorzugsweise Kühlrippen oder -dome aufweist, die vom übrigen Leistungsmodul weg weisen.

Insbesondere kann der dritte Körper dem oben schon erläuterten ersten Körper und der vierte Körper dem oben schon erläuterten zweiten Körper entsprechen.

Vorzugsweise findet das vorgeschlagene Leistungsmodul bzw. die vorgeschlagene Modulanordnung Anwendung in einem Gleichrichter, Wechselrichter bzw. ganz allgemein Umrichter oder Stromrichter. Insbesondere kann das vorgeschlagene Leistungsmodul bzw. die vorgeschlagene Modulanordnung oder ein entsprechender Umrichter bei elektrisch oder hybrid-angetriebenen Fahrzeugen, wie zum Beispiel bei Zügen, Autos oder Flugzeugen eingesetzt werden.

Im Folgenden wird die Erfindung anhand der in den Figuren dargestellten Ausführungsbeispiele näher beschrieben und erläutert. Es zeigen:
- FIG 1-6: ein erstes bis sechstes Ausführungsbeispiel des vorgeschlagenen Leistungsmoduls,
- FIG 7: ein Ausführungsbeispiel der vorgeschlagenen Modulanordnung und
- FIG 8&9: ein siebtes und achtes Ausführungsbeispiel des vorgeschlagenen Leistungsmoduls.

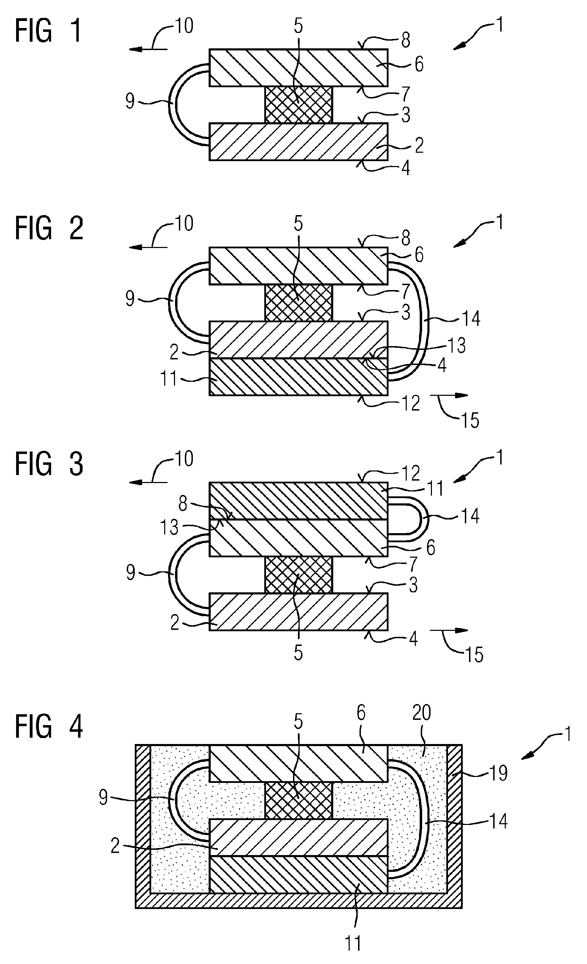

Figur 1 zeigt ein erstes Ausführungsbeispiel des vorgeschlagenen Leistungsmoduls 1, wobei ein Querschnitt durch das Leistungsmodul 1 dargestellt ist.

Das Leistungsmodul 1 weist eine erste Leiterplatte 2, ein Halbleiter-Bauelement 5, eine zweite Leiterplatte 6 sowie eine erste Flexleiterplatte 9 auf. Die erste Leiterplatte 2 weist dabei eine erste Oberfläche 3 und eine der ersten Oberfläche 3 gegenüberliegende zweite Oberfläche 4 auf. Entsprechend weist die zweite Leiterplatte 6 eine dritte Oberfläche 7 und eine der dritten Oberfläche 7 gegenüberliegende vierte Oberfläche 8 auf. Das Halbleiter-Bauelement 5 ist dabei an der ersten Oberfläche 3 angeordnet und kontaktiert die Oberfläche 7. Die erste Leiterplatte 2 ist mit der zweiten Leiterplatte 6 mittels der ersten Flexleiterplatte 9 elektrisch kontaktiert.

Die erste Leiterplatte 3 und die zweite Leiterplatte 6 sind dabei aufeinandergestapelt angeordnet, wobei die erste Oberfläche 3 der dritten Oberfläche 7 zugewandt ist. Im Rahmen des Ausführungsbeispiels ragt die erste Flexleiterplatte 9 aus der gestapelten Anordnung der ersten Leiterplatte 2 und der zweiten Leiterplatte 6 seitlich in einer ersten Richtung 10 heraus.

Figur 2 zeigt ein zweites Ausführungsbeispiel des vorgeschlagenen Leistungsmoduls 1. Gleiche Bezugszeichen wie in Figur 1 bezeichnen dabei gleiche Gegenstände. Da einige Ähnlichkeiten vorliegen, werden im Folgenden einige Unterschiede des zweiten Ausführungsbeispiels des vorgeschlagenen Leistungsmoduls 1 im Vergleich zum ersten Ausführungsbeispiel erläutert.

Das Leistungsmodul 1 weist weiterhin eine dritte Leiterplatte 11 sowie eine zweite Flexleiterplatte 14 auf. Die dritte Leiterplatte 11 weist wiederum eine fünfte Oberfläche 12 und eine der fünften Oberfläche 12 gegenüberliegende sechste Oberfläche 13 auf. Die zweite Leiterplatte 6 ist dabei mittels der zweiten Flexleiterplatte 14 mit der dritten Leiterplatte 11 elektrisch kontaktiert.

Die erste Leiterplatte 2, die zweite Leiterplatte 6 und die dritte Leiterplatte 11 sind dabei derart aufeinandergestapelt angeordnet, dass die zweite Oberfläche 4 der sechsten Oberfläche 13 zugewandt ist. Im Rahmen des Ausführungsbeispiels ragt die zweite Flexleiterplatte 14 aus der gestapelten Anordnung der drei Leiterplatten 2, 6, 11 seitlich in einer zweiten Richtung 15 heraus, welche der ersten Richtung 10 entgegengesetzt ist.

Figur 3 zeigt ein drittes Ausführungsbeispiel des vorgeschlagenen Leistungsmoduls 1.

Das dritte Ausführungsbeispiel ist dem zweiten Ausführungsbeispiel recht ähnlich. Im Unterschied zum zweiten Ausführungsbeispiel sind die erste Leiterplatte 2, die zweite Leiterplatte 6 und die dritte Leiterplatte 11 jedoch derart aufeinandergestapelt angeordnet, dass die vierte Oberfläche 8 der sechsten Oberfläche 13 zugewandt ist.

Figur 4 zeigt ein viertes Ausführungsbeispiel des vorgeschlagenen Leistungsmoduls 1.

Das vierte Ausführungsbeispiel entspricht im Wesentlichen dem zweiten Ausführungsbeispiel, wobei das Leistungsmodul 1 gemäß dem vierten Ausführungsbeispiel zusätzlich ein Gehäuse 19 aufweist, welches die gestapelte Anordnung der Leiterplatten 2, 6, 11 teilweise einhaust. Weiterhin ist die gestapelte Anordnung der Leiterplatten 2, 6, 11 teilweise mit einer Vergussmasse 20 umschlossen. Das Gehäuse 19 und die Vergussmasse 20 können dabei insbesondere in ein und demselben Mouldingprozess erzeugt werden, so dass das Gehäuse 19 also entweder dauerhaft Teil des Aufbaus sein kann oder nur temporär als Teil des Werkzeuges für den Verguss zur Formgebung benutzt wird.

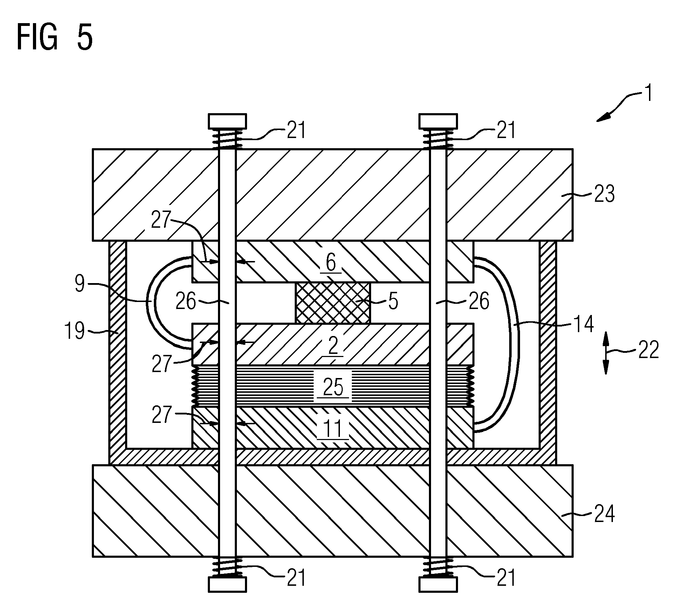

Figur 5 zeigt ein fünftes Ausführungsbeispiel des vorgeschlagenen Leistungsmoduls.

Bei dem fünften Ausführungsbeispiel handelt es sich um eine Abwandlung des Leistungsmoduls 1 gemäß dem zweiten Ausführungsbeispiel. Im Unterschied zum zweiten Ausführungsbeispiel weist das Leistungsmodul 1 nunmehr ein flexibles Ausgleichselement 25 auf, welches zwischen der ersten Leiterplatte 2 und der dritten Leiterplatte 11 angeordnet ist. Allerdings kann das jeweilige Leistungsmodul 1 des zweiten Ausführungsbeispiels bzw. des dritten Ausführungsbeispiels ebenfalls ein derartiges, flexibles Ausgleichselement 25 aufweisen, welches beim zweiten Ausführungsbeispiel zwischen der sechsten Oberfläche 13 und der zweiten Oberfläche 4 und beim dritten Ausführungsbeispiel zwischen der sechsten Oberfläche 13 und der vierten Oberfläche 8 angeordnet ist.

Weiterhin weisen die drei Leiterplatten 2, 6, 11 jeweils Aussparungen 27 auf, durch welche ein jeweiliger Zentrierstift 26 zur Positionierung der drei Leiterplatten 2, 6, 11 hindurchgeführt ist. In Stapelrichtung 22 werden die drei Leiterplatten 2, 6, 11 von einem ersten Körper 23 und einem zweiten Körper 24 eingefasst, wobei der erste Körper 23 und der zweite Körper 24 passend angeordnete Durchgangsbohrungen aufweisen, durch welche der jeweilige Zentrierstift 26 hindurchgeführt wird. Denkbar ist dabei, dass der jeweilige Zentrierstift 26 lediglich in einen der Körper 23 oder 24 eintaucht und nicht komplett hindurchgeführt wird, wodurch ebenfalls bereits eine Positionierung bzw. Fixierung ermöglicht wird.

Der jeweilige Zentrierstift 26 weist an seinem jeweiligen Ende ein Federelement 21 auf, mittels welchem die gestapelte Anordnung der Leiterplatten 2, 6, 11 in Stapelrichtung 22 zwischen einem ersten Körper 23 und einem zweiten Körper 24 eingespannt werden kann. Das jeweilige Federelement 21 ist dabei als optional anzusehen. Bspw. kann der erste Körper 23 als Kühlkörper und der zweite Körper 24 als Kühlkörper oder weitere Leiterplatte ausgestaltet sein.

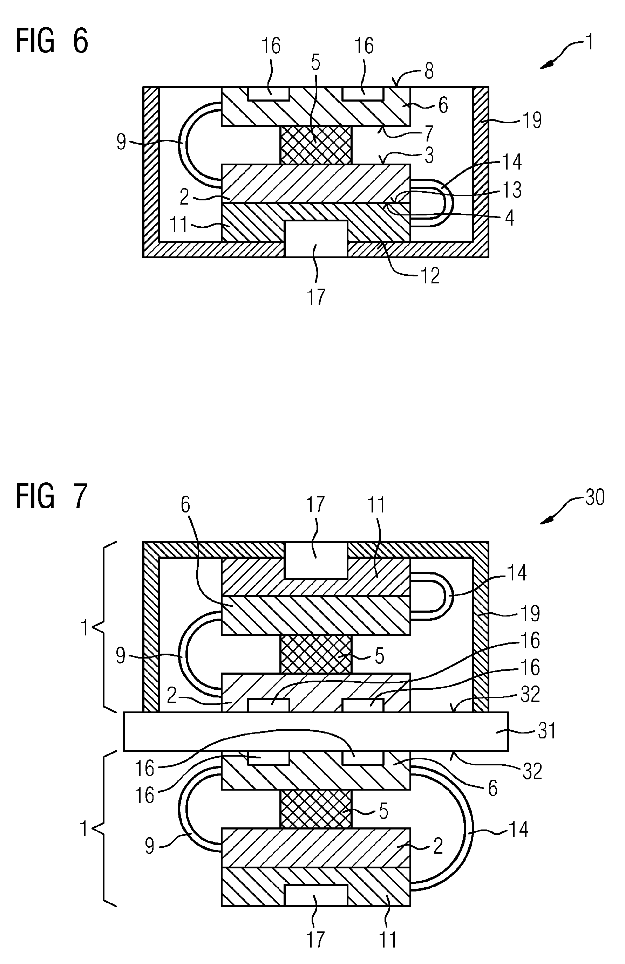

Figur 6 zeigt ein sechstes Ausführungsbeispiel des vorgeschlagenen Leistungsmoduls 1.

Das Leistungsmodul 1 gemäß dem sechsten Ausführungsbeispiel ist jenem des zweiten Ausführungsbeispiels ähnlich. Nunmehr stellt die zweite Flexleiterplatte 14 eine elektrische Kontaktierung der ersten Leiterplatte 2 mit der dritten Leiterplatte 11 her.

Weiterhin weist das Leistungsmodul 12 elektrische Kontaktstellen 16 und eine weitere elektrische Kontaktstelle 17 auf. Das Halbleiter-Bauelement 5 ist bspw. ein Transistor, wobei die beiden elektrischen Kontaktstellen 16 für den Gate-Kontakt sowie entweder für den Source- oder für den Drain-Kontakt des Transistors verwendet werden und wobei die weitere elektrische Kontaktstelle 17 für den Drain- oder Source-Kontakt des Transistors verwendet wird. Bspw. kann das Halbleiter-Bauelement 5 zusätzlich eine Diode umfassen, die auch als separates Bauteil ausgeführt sein kann.

Wie in Figur 6 angedeutet, sind die beiden elektrischen Kontaktstellen 16 an der vierten Oberfläche 8 der zweiten Leiterplatte 6 und die weitere elektrische Kontaktstelle 17 an der fünften Oberfläche 12 der dritten Leiterplatte 11 angeordnet. Dabei ist die weitere elektrische Kontaktstelle 17 durch eine Durchgangsöffnung des Gehäuses 19 hindurchgeführt.

Figur 7 zeigt ein Ausführungsbeispiel der vorgeschlagenen Modulanordnung 30.

Die Modulanordnung 30 weist zwei Leistungsmodule 1 sowie eine weitere Leiterplatte 31 auf. Die beiden Leistungsmodule 1 sind auf einander gegenüberliegenden Oberflächen 32 der weiteren Leiterplatte 31 angeordnet. Bei den zwei Leistungsmodulen 1 kann es sich dabei um gleiche oder unterschiedliche Leistungsmodule 1, insbesondere gemäß einem der zuvor erläuterten Ausführungsbeispiele, handeln. Wie in Figur 7 angedeutet, können hierbei die Ausführungsbeispiele aus den Figuren 2 und 3 zu einer Halbbrücke kombiniert werden.

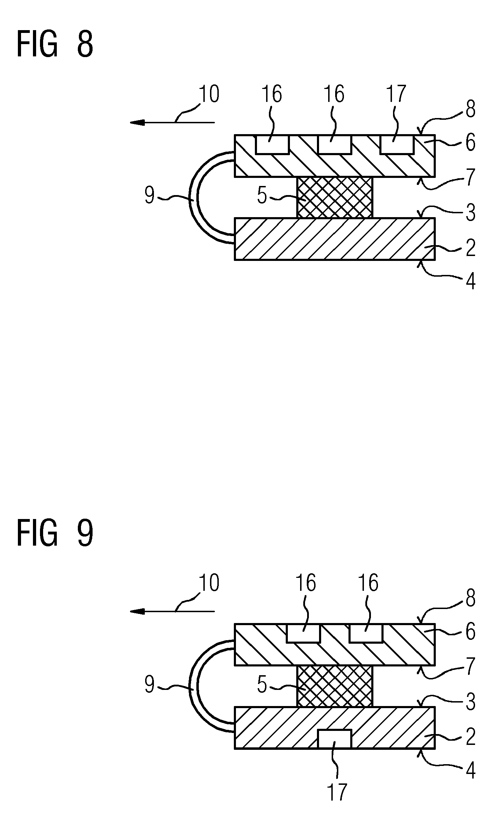

Figur 8 zeigt ein siebtes Ausführungsbeispiel des vorgeschlagenen Leistungsmoduls 1.

Das siebte Ausführungsbeispiel entspricht dabei im Wesentlichen dem ersten Ausführungsbeispiel des vorgeschlagenen Leistungsmoduls. Die zweite Leiterplatte 6 weist dabei an der vierten Oberfläche 8 zwei elektrische Kontaktstellen 16 und eine weitere elektrische Kontaktstelle 17 auf. Die jeweiligen Kontaktstellen können, wie weiter oben schon erläutert, bspw. als Kontaktstellen für ein als Transistor ausgestaltetes Halbleiter-Bauelement dienen.

Figur 9 zeigt ein achtes Ausführungsbeispiel des vorgeschlagenen Leistungsmoduls 1.
Das achte Ausführungsbeispiel entspricht dabei im Wesentlichen dem ersten Ausführungsbeispiel des vorgeschlagenen Leistungsmoduls. Die zweite Leiterplatte 6 weist dabei an der vierten Oberfläche 8 zwei elektrische Kontaktstellen 16 und die erste Leiterplatte 2 an der zweiten Oberfläche 4 eine weitere elektrische Kontaktstelle 17 auf. Die jeweiligen Kontaktstellen können, wie weiter oben schon erläutert, bspw. als Kontaktstellen für ein als Transistor ausgestaltetes Halbleiter-Bauelement dienen.

Zusammenfassend betrifft die Erfindung ein Leistungsmodul umfassend eine erste Leiterplatte aufweisend eine erste Oberfläche und eine der ersten Oberfläche gegenüberliegend angeordnete zweite Oberfläche sowie zumindest ein Halbleiter-Bauelement, welches an der ersten Oberfläche angeordnet ist. Weiterhin betrifft die Erfindung eine Modulanordnung aufweisend zumindest zwei derartige Leistungsmodule sowie ein Verfahren zur Herstellung eines Leistungsmoduls. Um verbesserte Leistungsmodule bzw. Modulanordnungen bereitzustellen, wird vorgeschlagen, dass das Leistungsmodul weiterhin eine zweite Leiterplatte aufweisend eine dritte Oberfläche und eine der dritten Oberfläche gegenüberliegend angeordnete vierte Oberfläche, wobei die erste Leiterplatte und die zweite Leiterplatte derart aufeinander gestapelt angeordnet sind, dass die erste Oberfläche der dritten Oberfläche zugewandt ist, und eine erste Flexleiterplatte aufweist, wobei die erste Leiterplatte mit der zweiten Leiterplatte mittels der ersten Flexleiterplatte elektrisch kontaktiert ist. Weiterhin wird vorgeschlagen, dass die Modulanordnung zumindest zwei der vorgeschlagenen Leistungsmodule sowie eine weitere Leiterplatte aufweist, wobei die zumindest zwei Leistungsmodule auf einander gegenüberliegenden Oberflächen der weiteren Leiterplatte angeordnet sind.

Schließlich werden die folgenden Verfahrensschritte vorgeschlagen:
- Bereitstellen eines Leiterplatten-Stranges umfassend die erste Leiterplatte, die erste Flexleiterplatte und die zweite Leiterplatte, sowie ggf. die zweite Flexleiterplatte und die dritte Leiterplatte,
- Gestapeltes Anordnen der ersten Leiterplatte und der zweiten Leiterplatte derart, dass die erste Oberfläche der dritten Oberfläche zugewandt ist,
- Ggf. gestapelte Anordnen ersten Leiterplatte, der zweiten Leiterplatte und der dritten Leiterplatte derart, dass die zweite Oberfläche oder die vierte Oberfläche der sechsten Oberfläche zugewandt ist.

## Patentansprüche

1. Leistungsmodul (1) umfassend
- eine erste Leiterplatte (2) aufweisend eine erste Oberfläche (3) und eine der ersten Oberfläche (3) gegenüberliegend angeordnete zweite Oberfläche (4),
- zumindest ein Halbleiter-Bauelement (5), welches an der ersten Oberfläche (3) angeordnet ist,
- eine zweite Leiterplatte (6) aufweisend eine dritte Oberfläche (7) und eine der dritten Oberfläche (7) gegenüberliegend angeordnete vierte Oberfläche (8),
wobei die erste Leiterplatte (2) und die zweite Leiterplatte (6) derart aufeinander gestapelt angeordnet sind, dass die erste Oberfläche (3) der dritten Oberfläche (7) zugewandt ist, und
- eine erste Flexleiterplatte (9),
wobei die erste Leiterplatte (2) mit der zweiten Leiterplatte (6) mittels der ersten Flexleiterplatte (9) elektrisch kontaktiert ist.

2. Leistungsmodul (1) nach Anspruch 1,
wobei die erste Flexleiterplatte (9) aus der gestapelten Anordnung der ersten Leiterplatte (2) und der zweiten Leiterplatte (6) seitlich in einer ersten Richtung (10) herausragt.

3. Leistungsmodul (1) nach einem der vorhergehenden Ansprüche,
umfassend eine dritte Leiterplatte (11) aufweisend eine fünfte Oberfläche (12) und eine der fünften Oberfläche (12) gegenüberliegend angeordnete sechste Oberfläche (13),
wobei die erste Leiterplatte (2), die zweite Leiterplatte (6) und die dritte Leiterplatte (11) derart aufeinander gestapelt angeordnet sind, dass die zweite Oberfläche (4) oder die vierte Oberfläche (8) der sechsten Oberfläche (13) zugewandt ist, und
- eine zweite Flexleiterplatte (14),
wobei die erste Leiterplatte (2) oder die zweite Leiterplatte (6) mit der dritten Leiterplatte (11) mittels der zweiten Flexleiterplatte (14) elektrisch kontaktiert ist.

4. Leistungsmodul (1) nach den Ansprüchen 2 und 3,
wobei die zweite Flexleiterplatte (14) aus der gestapelten Anordnung der ersten Leiterplatte (2), der zweiten Leiterplatte (6) und der dritten Leiterplatte (11) seitlich in einer der ersten Richtung (10) entgegengesetzten zweiten Richtung (15) herausragt.

5. Leistungsmodul (1) nach einem der vorhergehenden Ansprüche,
wobei das zumindest eine Halbleiter-Bauelement (5) einen Transistor, insbesondere in Form eines "bare die", umfasst, wobei das Leistungsmodul (1) zumindest zwei elektrische Kontaktstellen (16), insbesondere für den Gate-Anschluss sowie für den Source- oder den Drain-Anschluss des Transistors, sowie eine weitere elektrische Kontaktstelle (17), insbesondere für den Drain- oder den Source-Anschluss des Transistors, aufweist.

6. Leistungsmodul (1) nach einem der vorhergehenden Ansprüche,
wobei das zumindest eine Halbleiter-Bauelement (5) eine Diode umfasst.

7. Leistungsmodul (1) nach einem der vorhergehenden Ansprüche,
wobei die erste Leiterplatte (2) sowie vorzugsweise auch die zweite Leiterplatte (6) jeweils einen Kupferkern aufweisen.

8. Leistungsmodul (1) nach einem der vorhergehenden Ansprüche,
aufweisend ein Gehäuse (19), welches die gestapelte Anordnung der ersten Leiterplatte (2), der zweiten Leiterplatte (6) und ggf. der dritten Leiterplatte (11) zumindest teilweise einhaust.

9. Leistungsmodul (1) nach einem der vorhergehenden Ansprüche,
wobei die gestapelte Anordnung der ersten Leiterplatte (2), der zweiten Leiterplatte (6) und ggf. der dritten Leiterplatte (11) zumindest teilweise mittels einer Vergussmasse (20), insbesondere mittels eines Silikonvergusses, umschlossen ist.

10. Leistungsmodul (1) nach einem der vorhergehenden Ansprüche,
aufweisend zumindest ein Federelement (21), mittels welchem jeweils die gestapelte Anordnung der ersten Leiterplatte (2), der zweiten Leiterplatte (6) und ggf. der dritten Leiterplatte (11) in Richtung der Stapelrichtung (22) zwischen einem ersten Körper (23) und einem zweiten Körper (24) eingespannt werden kann.

11. Leistungsmodul (1) nach einem der vorhergehenden Ansprüche,
aufweisend zumindest ein flexibles Ausgleichselement (25), welches jeweils auf einer der Oberflächen der ersten Leiterplatte (2), der zweiten Leiterplatte (6) und ggf. der dritten Leiterplatte (11) angeordnet ist.

12. Leistungsmodul (1) nach einem der vorhergehenden Ansprüche,
aufweisend zumindest einen Zentrierstift (26) zur Positionierung der ersten Leiterplatte (2), der zweiten Leiterplatte (6) und ggf. der dritten Leiterplatte (11),
wobei die jeweilige Leiterplatte vorzugsweise eine jeweilige Aussparung (27) zur Aufnahme des jeweiligen Zentrierstifts (26) aufweist.

13. Leistungsmodul (1) nach einem der vorhergehenden Ansprüche,
aufweisend einen dritten Körper und einen vierten Körper, wobei die gestapelte Anordnung der ersten Leiterplatte (2), der zweiten Leiterplatte (6) und ggf. der dritten Leiterplatte (11) in Richtung der Stapelrichtung (22) zwischen dem dritten Körper und dem vierten Körper angeordnet sind,
wobei der dritte Körper ein Kühlkörper ist und
wobei der vierte Körper ein Kühlkörper oder eine weitere Leiterplatte ist.

14. Modulanordnung (30) aufweisend
- zumindest zwei Leistungsmodule (1) nach einem der vorhergehenden Ansprüche und
- eine weitere Leiterplatte (31),
wobei die zumindest zwei Leistungsmodule (1) auf einander gegenüberliegenden Oberflächen (32) der weiteren Leiterplatte (31) angeordnet sind.

15. Verfahren zur Herstellung eines Leistungsmoduls (1) nach einem der Ansprüche 1-13 umfassend die Verfahrensschritte:
- Bereitstellen eines Leiterplatten-Stranges umfassend die erste Leiterplatte (2), die erste Flexleiterplatte (9) und die zweite Leiterplatte (6), sowie ggf. die zweite Flexleiterplatte (14) und die dritte Leiterplatte (11),
- Gestapeltes Anordnen der ersten Leiterplatte (2) und der zweiten Leiterplatte (6) derart, dass die erste Oberfläche (3) der dritten Oberfläche (7) zugewandt ist,
- Ggf. gestapelte Anordnen ersten Leiterplatte (2), der zweiten Leiterplatte (6) und der dritten Leiterplatte (11) derart, dass die zweite Oberfläche (4) oder die vierte Oberfläche (8) der sechsten Oberfläche (13) zugewandt ist.
